# EUROPEAN PATENT APPLICATION

(11) **EP 3 514 950 A1**
(43) Date of publication of application: **24.07.2019**
(21) Application number: 17872875.4
(22) Date of filing: 29.12.2017
(51) Int. Cl.: H02S 50/10, H01L 31/048

(54) **ANALOG COMPONENT OF SOLAR CELL MODULE AND MANUFACTURING METHOD FOR SIMULATION CELL CHIP LAYER**

(71) Applicant: Miasolé Equipment Integration (Fujian) Co., Ltd., 362005 Quanzhou Fujian (CN)
(72) Inventor: The designation of the inventor has not yet been filed
(74) Representative: D'Halleweyn, Nele Veerle Trees Gertrudis
(86) International application number: PCT/CN2017/120077
(87) International publication number: WO 2019/109432

(57) **Abstract**

The present application provides a simulation module of a solar cell module and a method for manufacturing a simulation cell chip layer. The simulation module of the solar cell module includes a support plate; a first Teflon layer placed on the support plate; a cell chip layer placed on the first Teflon layer; a second Teflon layer placed on the cell chip layer; and a foam layer placed on the second Teflon layer.

## Description

### Technical Field

The present application relates to, but is not limited to, the technical field of photovoltaic power generation, and in particular to a simulation module of a solar cell module and a method for manufacturing a simulation cell chip layer.

### Background

At present, global solar cell industry has been developed to a more mature stage, and lamination packaging of a solar cell module has a relatively mature technology. It is the most common method at the present stage to verify the production process of a solar cell by evaluating the performance of the solar cell module (i.e., equivalent to evaluating a surface of its core component, a flexible cell wire sheet), however, the main drawback of this method is that the solar cell module has a long production period and its performance cannot be fed back in time.

### Summary

The following is an overview of the subject matter described in detail herein. This overview is not intended to limit the scope of the claims.

The present application provides a simulation module of a solar cell module, where changes of melting and resolidification will occur in an electrode on a surface of a cell chip layer after being laminated and heated to form a state similar to that of a cell chip in the solar cell module and to form a simulation cell chip layer, and the corresponding verification and guidance for optimization are performed on the production process of the solar cell by evaluating the performance of feedback of the simulation cell chip layer, the production period of the simulation cell chip layer is effectively shortened relative to the solar cell module.

The application provides a simulation module of a solar cell module, for verifying and optimizing production process of a solar cell after lamination at a set temperature, the simulation module of the solar cell module comprising: a support plate; a first Teflon layer placed on the support plate; a cell chip layer placed on the first Teflon layer; a second Teflon layer placed on the cell chip layer; and a foam layer placed on the second Teflon layer; where the support plate, the first Teflon layer, the cell chip layer, the second Teflon layer and the second foam layer all are able to be resistant to a high temperature not less than 180°C.

Optionally, the cell chip layer includes a plurality of cell chips, and the plurality of cell chips are arranged at intervals from each other.

Optionally, the cell chips are flexible cell chips.

Optionally, the support plate is a halogen-free epoxy laminate, the first Teflon layer and the second Teflon layer are Teflon coated heat resistant fabric, and the foam layer is a heat resistant foam plate.

The present invention provides a method for manufacturing a simulation cell chip layer, comprising:
sequentially laminating a first Teflon layer, a cell chip layer, a second Teflon layer and a foam layer on a support plate to form a simulation module;
feeding the simulation module into a laminating machine, and then vacuumizing the laminating machine and preheating the simulation module;
pressurizing the laminating machine, where a pressure acts on the simulation module and rises to a set value pressure within a first set time, and a temperature during pressurization is kept at a set temperature;
maintaining the set value pressure at the set temperature for a second set time;
sending the simulation module out of the laminating machine and cooling the simulation module.

Optionally, the step of vacuumizing the laminating machine and preheating the simulation module includes: vacuumizing the laminating machine for a third set time and preheating the simulation module within the third set time.

Optionally, a temperature for preheating is 40°C to 100°C, and the third set time is 2 min to 6 min.

Optionally, the first set time is 0.5 min to 2 min, the set value pressure is 80 Kpa to 120 Kpa, and the set temperature is 140°C to 180°C.

Optionally, the second set time is 5 min to 20 min.

Optionally, the support plate is a halogen-free epoxy laminate, the first Teflon layer and the second Teflon layer are Teflon coated heat resistant fabric, the foam layer is a heat resistant foam plate, and the cell chip layer includes a plurality of flexible cell chips arranged at intervals; where the halogen-free epoxy laminate, the Teflon coated heat resistant fabric, the heat resistant foam plate and the flexible cell chip all are able to be resistant to a high temperature not less than 180°C.

For the simulation module of the solar cell module provided by the present application, changes of melting and resolidification will occur in the electrode on the surface of the cell chip layer (alight receiving surface of the cell chip of the cell chip layer is provided with an electrode that will be melted and resolidified after being pressed and heated) after being laminated and heated to form a state similar to that of the cell chip in the solar cell module (i.e., to form the simulation cell chip layer), the simulation cell chip layer simulates the cell chip of the solar cell module, and the corresponding verification and guidance for optimization are performed on the production process of the solar cell by evaluating the performance of the feedback of the simulation cell chip layer, the production period of the simulation cell chip layer is effectively shortened relative to that of the solar cell module.

The structure of the electrode is similar to a sandwich, i.e. APA/nickel-plated copper core wire/APA, the APA will be melted and resolidified in a lamination process; the APA is a kind of film-like material containing polyethylene terephthalate and adhesive resin, and mainly plays a role in adhesion, realizing ohmic contact between the nickel-plated copper core wire and the cell.

Furthermore, the simulation cell chip layer has a slightly longer storage time than the cell chip without lamination under conventional conditions.

Other features and advantages of the present application will be set forth in the subsequent specification, and partially become clearer in the specification, or are understood by implementation of the present application. The object and other advantages of the present application may be realized and attained by the structure particularly pointed out in the specification, claims, and drawings.

### Brief Description of Drawings

The accompanying drawings are used to provide further understanding for the technical scheme of the present application and form a part of the specification, and together with the embodiments of the present application serve to explain the technical scheme of the present application, and do not constitute the limitation on the technical scheme of the present application.
Fig. 1 is a structural schematic diagram of the simulation module of the solar cell module according to one embodiment of the present application;
Fig. 2 is a flowchart of the method for fabricating the simulation cell chip layer according to one embodiment of the present application.

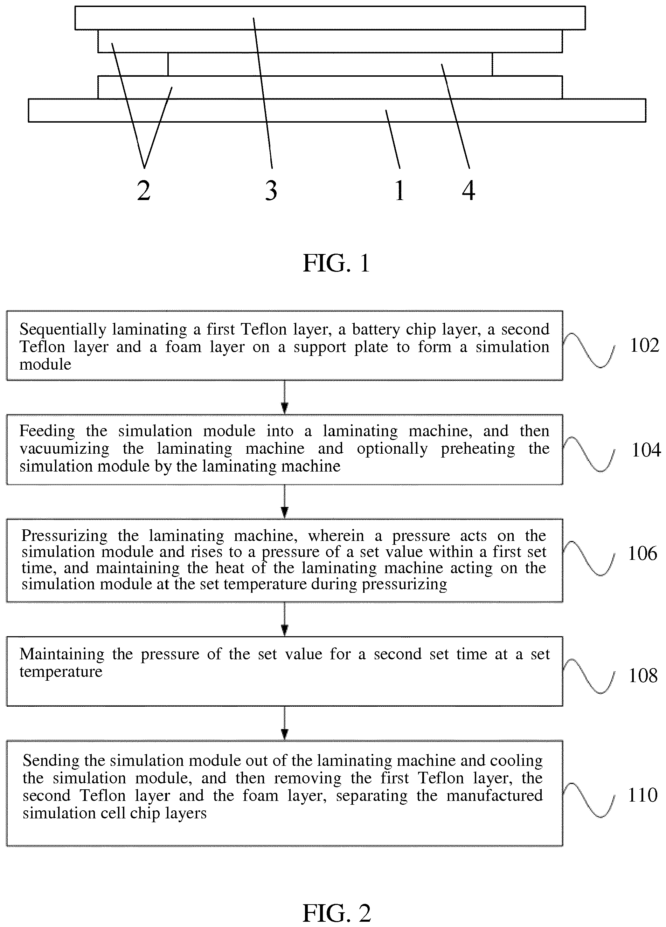

The correspondence between the reference numerals and the component names in Fig. 1 is as follows:
1 halogen-free epoxy laminate, 2 Teflon coated heat resistant fabric, 3 heat resistant foam plate, 4 flexible cell chip.

### Detailed Description

Embodiments of the present application will be described in detail below with reference to the accompanying drawings in order to make the object, technical schemes and advantages of the present application be more clearly understood. It should be noted that the embodiments and features in the embodiments of the present application can be combined with each other arbitrarily in the case of no conflict.

In the following depiction, numerous specific details are set forth in order to facilitate sufficiently understanding the present application, but the present application also can be implemented by adopting other manners other than that as described herein, and therefore, the protection scope of the present application is not limited by the specific embodiments disclosed below.

The simulation module of the solar cell module and the method for manufacturing the simulation cell chip layer according to some embodiments of the present application are described below with reference to the accompanying drawings.

The simulation module of the solar cell module provided by an embodiment of the present invention is used for verifying and optimizing the production process of the solar cell after lamination at the set temperature, and the simulation module of the solar cell module includes a support plate; a first Teflon layer placed on the support plate; a cell chip layer placed on the first Teflon layer; a second Teflon layer placed on the cell chip layer; and a foam layer placed on the second Teflon layer; where the support plate, the first Teflon layer, the cell chip layer, the second Teflon layer and the second foam layer all are able to be resistant to a high temperature not less than 180°C.

For the simulation module of the solar cell module provided by the embodiment of the invention, changes of melting and resolidification will occur in the electrode on the surface of the cell chip layer (the light receiving surface of the cell chip of the cell chip layer is provided with an electrode that will be melted and resolidified after being pressed and heated) after being laminated and heated to form a state similar to that of the cell chip in the solar cell module (i.e., to form a simulation cell chip layer), the simulation cell chip layer simulates a cell chip of the solar cell module, and the corresponding verification and guidance for optimization are performed on the production process of the solar cell by evaluating the performance of the feedback of the simulation cell chip layer, the production period of the simulation cell chip layer is effectively shortened relative to that of the solar cell module.

The structure of the electrode is similar to a sandwich, APA/nickel-plated copper core wire/APA, APA will be melted and resolidified in the lamination process; APA is a kind of film-like material containing polyethylene terephthalate and adhesive resin, and mainly plays a role in adhesion, realizing ohmic contact between the nickel-plated copper core wire and the cell.

Moreover, the simulation cell chip layer has a slightly longer storage time than the cell chip without lamination under conventional conditions.

The set temperature is 140°C to 180°C, and the pressure of lamination is 80 Kpa to 120 Kpa.

The cell chip layer includes a plurality of cell chips, and the plurality of cell chips are arranged at intervals from each other without overlapping, thereby ensuring that the final state cell chip on the simulation cell chip layer and the cell chip in the solar cell module have a similar state (if overlapping, the state at the overlapped position after lamination at the set temperature is not similar to the state of the cell chip in the solar cell module).

Preferably, as shown in Fig. 1, the cell chips are flexible cell chips 4, the precision of the final-state flexible cell chip after lamination at the set temperature is reliable, and the performance of the final-state flexible cell chip is closer to that of the solar cell module (i.e.: close to the performance of the cell chip within the solar cell module).

The cell chip laminated at the set temperature corresponds to the final-state cell chip, and the flexible cell chip laminated at the set temperature corresponds to the final-state flexible cell chip. Specifically, as shown in Fig. 1, the support plate is a halogen-free epoxy laminate 1, the first Teflon layer and the second Teflon layer are Teflon coated heat resistant fabric 2, and the foam layer is a heat resistant foam plate 3, the time for manufacturing the final-state flexible cell chip is short, and the manufacturing process is simple, the simulation module can be laminated in batch, and the halogen-free epoxy laminate 1, the Teflon coated heat resistant fabric 2 and the heat resistant foam plate 3 all can be recycled.

The method for manufacturing the simulation cell chip layer provided by an embodiment of the invention, as shown in Fig. 2, includes the following steps:
Step 102, Sequentially laminating a first Teflon layer, a cell chip layer, a second Teflon layer and a foam layer on a support plate to form a simulation module;
Step 104, Feeding the simulation module into a laminating machine, and then vacuumizing the laminating machine and optionally preheating the simulation module by the laminating machine;
Step 106, Pressurizing the laminating machine, where a pressure acts on the simulation module and rises to a pressure of a set value within a first set time, and maintaining the heat of the laminating machine acting on the simulation module at the set temperature during pressurizing;
Step 108, Maintaining the pressure of the set value for a second set time at a set temperature;
Step 110, sending the simulation module out of the laminating machine and cooling the simulation module, and then removing the first Teflon layer, the second Teflon layer and the foam layer, separating the manufactured simulation cell chip layers. The first Teflon layer, the second Teflon layer and the foam layer can be recycled.

According to the method for manufacturing the simulation cell chip layer provided by the embodiment of the invention, changes of melting and resolidification will occur in the electrode on the surface of the cell chip layer (the light receiving surface of the cell chip of the cell chip layer is provided with an electrode that will be melted and resolidified after being pressed and heated) after being laminated and heated to form a state similar to that of the cell chip in the solar cell module (i.e., to form the simulation cell chip layer), the simulation cell chip layer simulates the cell chip of the solar cell module, and the corresponding verification and guidance for optimization are performed on the production process of the solar cell by evaluating the performance of the feedback of the simulation cell chip layer.

Moreover, the production period of the simulation cell chip layer is effectively shortened relative to the solar cell module.

The structure of the electrode is similar to a sandwich, APA/nickel-plated copper core wire/APA, APA will be melted and resolidified in the lamination process; APA is a kind of film-like material containing polyethylene terephthalate and adhesive resin, and mainly plays a role in adhesion, realizing ohmic contact between the nickel-plated copper core wire and the cell.

In step 104, the object of preheating the simulation module is to increase the temperature of the simulation module to a set temperature more rapidly in step 106, aiming at reducing the manufacturing time of the simulation cell chip layer, and the preheating process may also be removed if time permits, which also should be within the protection scope of the present application.

Specifically, the step of vacuumizing the laminating machine and optionally preheating the simulation module includes: vacuumizing the laminating machine for the third set time and optionally preheating the simulation module within the third set time. The preheating can make the simulation module easier to heat up to the set temperature in the subsequent process, effectively shortening the heating up time of the simulation module of the subsequent process, i.e. reducing the manufacturing time of the simulation cell chip layer. The temperature for preheating is 40-100°C(e.g.: 40°C, 60°C, 80°C or 100°C, etc., all of which can achieve the object of the present application), and the third set time is 2 min to 6 min (e.g.: 2 min, 4 min or 6 min, etc., all of which can achieve the object of the present application, and the production period of the simulation cell chip layer will be prolonged if the third set time exceeds 6 min).

Specifically, the first set time can be 0.5 min to 2 min (e.g. 30s, 1 min, 2 min, etc., all of which can achieve the object of the present application, and the production period of the simulation cell chip layer will be prolonged if the first set time exceeds 2 min), the set value can be 80 Kpa to 120 Kpa (e.g.: 80 Kpa, 100 Kpa, or 120 Kpa, etc., all of which can achieve the object of the present application), and the set temperature can be 140 to 180 (e.g.: 140 , 150 , 160 , 170 or 180 etc., all of which can achieve the object of the present application).

Alternatively, the second set time is 5 min to 20 min (e.g.: 5 min, 10 min, 15 min or 20 min etc., all of which can achieve the object of the present application, and the production period of the simulation cell chip layer will be prolonged if the second set time exceeds 20 min).

Specifically, the support plate is a halogen-free epoxy laminate, the first Teflon layer and the second Teflon layer are Teflon coated heat resistant fabric, the foam layer is a heat resistant foam plate, and the cell chip layer includes a plurality of flexible cell chips arranged at intervals; and the halogen-free epoxy laminate, the Teflon coated heat resistant fabric, the heat resistant foam plate and the flexible cell chip all are able to be resistant to a high temperature not less than 180°C, thereby preventing material damages during heating and pressurizing.

To sum up, changes of melting and resolidification will occur in the electrode on the surface of the cell chip layer (the light receiving surface of the cell chip of the cell chip layer is provided with an electrode that will be melted and resolidified after being pressed and heated) after being laminated and heated to form a state similar to that of the cell chip in the solar cell module (i.e., to form a simulation cell chip layer), the simulation cell chip layer simulates the cell chip of the solar cell module, and the corresponding verification and guidance for optimization are performed on the production process of the solar cell by evaluating the performance of the feedback of the simulation cell chip layer, the production period of the simulation cell chip layer is effectively shortened relative to the solar cell module.

Moreover, the simulation cell chip layer has a slightly longer storage time than the cell chip without lamination under conventional conditions.

Throughout the descriptions of the present application, the terms "mount", "connect", "link", "fix" and the like all should be understood broadly, e.g., "link" can refer to fixed linking, and also can refer to removable linking, or integral linking; "connect" can refer to direct connection, and also can refer to indirect connection through an intermediate medium. It will be apparent to those of ordinary skill in the art that the specific meanings of the above terms in the present application can be understood in light of the specific circumstances.

In the descriptions of this specification, the terms "one embodiment", "some embodiments", "specific embodiment" and the like mean that particular features, structures, materials, or characteristics described in combination with the embodiment or example are included in at least one embodiment or example of the present application. In this specification, schematic expressions of the above terms do not necessarily refer to the same embodiment or example. Moreover, the described particular features, structures, materials, or characteristics can be combined in suitable manner in any one or more embodiments or examples.

The disclosure is the example of the principle of embodiments of the present application and is not intended to limit the present application in any form or substance, or to limit the present application to particular embodiments. It will be apparent to those skilled in the art that variations, changes, modifications and evolutions can be made to the elements, methods, systems and the like of the technical schemes of the embodiments of the present application without departing from the principles, spirits, and scopes as defined in the embodiments, technical schemes, for example, the claims of the present application. Such variations, changes, modifications, and evolutions are all included in the equivalent embodiments of the present application; and these equivalent embodiments are all included within the scopes of the present application as defined by the claims. Although embodiments of the present application can be embodied in many different forms, some embodiments of the present invention are described in detail herein. Furthermore, the embodiments of the present application include any possible combination of some or all of the various embodiments described herein, and are also included in the scopes of the present application as defined by the claims. All patents, patent applications, and other cited materials mentioned in the present application or anywhere in any cited patent, cited patent application, or other cited materials are hereby integrally incorporated by reference.

The above disclosure is intended to be illustrative and not exhaustive. Many variations and alternative schemes will be implied by the specification to those skilled in the art. All such alternative schemes and variations are intended to be included in the scope of the present claims, where the term "included" means "included, but not limited to". The description of alternative embodiments of the present invention has been completed herein. Those skilled in the art can recognize other equivalent transformations of the embodiments described herein, and these equivalent transformations are also encompassed by the claims appended hereto.

### Industrial Applicability

For the simulation module of the solar cell module provided by the present application, after lamination and heating, changes of melting and resolidification will occur in the electrode on the surface of the cell chip layer to form a state similar to that of the cell chip in the solar cell module to form a simulation cell chip layer, the simulation cell chip layer simulates the cell chip of the solar cell module, and the corresponding verification and guidance for optimization are performed on the production process of the solar cell by evaluating the performance of the feedback of the simulation cell chip layer, so that the period of the simulation cell chip layer is effectively shortened relative to the solar cell module.

## Claims

1. A simulation module of a solar cell module, for verifying and optimizing production process of a solar cell after lamination at a set temperature, the simulation module of the solar cell module comprising:
a support plate;
a first Teflon layer placed on the support plate;
a cell chip layer placed on the first Teflon layer;
a second Teflon layer placed on the cell chip layer; and
a foam layer placed on the second Teflon layer;
wherein the support plate, the first Teflon layer, the cell chip layer, the second Teflon layer and the second foam layer all are able to be resistant to a high temperature not less than 180°C.

2. The simulation module of the solar cell module according to claim 1, wherein the cell chip layer comprises a plurality of cell chips, and the plurality of cell chips are arranged at intervals from each other.

3. The simulation module of the solar cell module according to claim 2, wherein the cell chips are flexible cell chips.

4. The simulation module of the solar cell module according to claims 1 to 3, wherein the support plate is a halogen-free epoxy laminate, the first Teflon layer and the second Teflon layer are Teflon coated heat resistant fabric, and the foam layer is a heat resistant foam plate.

5. A method for manufacturing a simulation cell chip layer, comprising:
sequentially laminating a first Teflon layer, a cell chip layer, a second Teflon layer and a foam layer on a support plate to form a simulation module;
feeding the simulation module into a laminating machine, and then vacuumizing the laminating machine and optionally preheating the simulation module;
pressurizing the laminating machine, wherein a pressure acts on the simulation module and rises to a set value pressure within a first set time, and a temperature during pressurization is kept at a set temperature;
maintaining the set value pressure at the set temperature for a second set time;
sending the simulation module out of the laminating machine and cooling the simulation module.

6. The method for manufacturing the simulation cell chip layer according to claim 5, wherein the step of vacuumizing the laminating machine and optionally preheating the simulation module comprises:
vacuumizing the laminating machine for a third set time and optionally preheating the simulation module within the third set time.

7. The method for manufacturing the simulation cell chip layer according to claim 6, wherein a temperature for preheating is 40°C to 100°C, and the third set time is 2 min to 6 min.

8. The method for manufacturing the simulation cell chip layer according to any one of claims 5 to 7, wherein the first set time is 0.5 min to 2 min, the set value pressure is 80 Kpa to 120 Kpa, and the set temperature is 140°C to 180°C.

9. The method for manufacturing the simulation cell chip layer according to any one of claims 5 to 8, wherein the second set time is 5 min to 20 min.

10. The method for manufacturing the simulation cell chip layer according to any one of claims 5 to 9, wherein the support plate is a halogen-free epoxy laminate, the first Teflon layer and the second Teflon layer are Teflon coated heat resistant fabric, the foam layer is a heat resistant foam plate, and the cell chip layer comprises a plurality of flexible cell chips arranged at intervals;
wherein the halogen-free epoxy laminate, the Teflon coated heat resistant fabric, the heat resistant foam plate and the flexible cell chip all are able to be resistant to a high temperature not less than 180°C.
